# EUROPEAN PATENT APPLICATION

(11) **EP 4 832 143 A1**
(43) Date of publication of application: **28.10.2026**
(21) Application number: 24919978.7
(22) Date of filing: 23.12.2024
(51) Int. Cl.: H01M 10/48, H01M 50/244, H01M 50/289, H01R 25/14

(54) **CELLS CONTACT SYSTEM (CCS) ASSEMBLY AND BATTERY PACK**

(30) Priority: 23.01.2024 CN 202410101394
(71) Applicant: Huawei Digital Power Technologies Co., Ltd., Shenzhen, Guangdong 518043 (CN)
(72) Inventor: ZHANG, Lingfeng, Shenzhen, Guangdong 518043 (CN); SHEN, Bingjie, Shenzhen, Guangdong 518043 (CN)
(74) Representative: Isarpatent
(86) International application number: PCT/CN2024/141503
(87) International publication number: WO 2025/156900

(57) **Abstract**

This application relates to the technical field of battery information collection modules, and in particular, to a cells contact system CCS assembly and a battery pack. The CCS assembly includes a signal collection board, an insulation mounting bracket, a thermally conductive member, and a temperature sensor. The insulation mounting bracket is fastened to a surface of a battery module, the battery module includes a plurality of battery cells that are sequentially arranged, and the insulation mounting bracket includes a mounting groove. The thermally conductive member is mounted in the mounting groove, a bottom wall of the mounting groove includes an opening, the opening faces the plurality of battery cells, and the thermally conductive member is in contact with surfaces of the plurality of battery cells through the opening. The temperature sensor collects temperature information of the thermally conductive member. The signal collection board is fastened to a side that is of the insulation mounting bracket and that faces away from the battery module, the signal collection board is connected to the temperature sensor, and the signal collection board is configured to: receive the temperature information collected by the temperature sensor, and transmit the temperature information to a controller. The CCS assembly detects the plurality of battery cells by using one temperature sensor, to reduce a quantity of temperature sensors and achieve structure optimization.

## Description

### CROSS-REFERENCE TO RELATED APPLICATIONS

This application claims priority to Chinese Patent Application No. 202410101394.3, filed with the China National Intellectual Property Administration on January 23, 2024, and entitled "CELLS CONTACT SYSTEM CCS ASSEMBLY AND BATTERY PACK", which is incorporated herein by reference in its entirety.

### TECHNICAL FIELD

This application relates to the technical field of battery information collection modules, and in particular, to a cells contact system CCS assembly and a battery pack.

### BACKGROUND

With development of new energy technologies, the new energy technologies are widely applied. Battery packs are used as an important part of the new energy technologies, and ensuring safety of the battery packs during use becomes an important issue. In a conventional technology, a cells contact system (cells contact system, CCS for short) assembly is usually used to collect a voltage and a temperature of a battery, and send collected voltage and temperature information to a battery monitoring unit, to detect the voltage and the temperature of the battery, and reduce battery fires.

However, the battery includes a plurality of battery cells. To detect a temperature of each battery cell, the CCS assembly in the conventional technology includes a plurality of temperature sensors, and each temperature sensor is configured to detect a temperature of one or two battery cells. Consequently, complexity of a battery management system is increased, and costs of the battery management system are also increased.

### SUMMARY

Embodiments of this application provide a cells contact system CCS assembly and a battery pack. The cells contact system assembly can reduce a quantity of temperature sensors, so that a structure of the cells contact system assembly is simplified, to optimize a structure of a battery management system, and reduce costs.

According to a first aspect, this application provides a cells contact system assembly. The cells contact system assembly includes a signal collection board, an insulation mounting bracket, a thermally conductive member, and a temperature sensor; the insulation mounting bracket is configured to be fastened to a surface of a battery module, the battery module includes a plurality of battery cells that are sequentially arranged, the insulation mounting bracket includes a mounting groove, and the mounting groove extends in an arrangement direction of the plurality of battery cells; the thermally conductive member is mounted in the mounting groove, a bottom wall of the mounting groove includes an opening, the opening faces the plurality of battery cells, and the thermally conductive member is in contact with surfaces of the plurality of battery cells through the opening for heat conduction; the temperature sensor is in contact with a surface of the thermally conductive member, to collect temperature information of the thermally conductive member; and the signal collection board is fastened to a side that is of the insulation mounting bracket and that faces away from the battery module, the signal collection board is electrically connected to the temperature sensor, and the signal collection board is configured to: receive the temperature information collected by the temperature sensor, and transmit, to a controller, the temperature information collected by the temperature sensor. The thermally conductive member is fastened in the mounting groove, the thermally conductive member is in contact with the battery cells through the opening of the bottom wall of the mounting groove, and a temperature generated by each battery cell can be collected by the thermally conductive member. When any one or more of the plurality of battery cells are faulty, it may be understood that, regardless of which battery cell is faulty, a temperature of the thermally conductive member changes when there is temperature abnormality. The temperature sensor can collect the temperature of the thermally conductive member in real time, and transmit temperature information to the controller through the signal collection board, to prevent a danger caused by an excessively high temperature of the battery cell. In addition, in this manner, an abnormal temperature of any one of the plurality of battery cells can be collected through one temperature sensor, so that a quantity of temperature sensors can be reduced, a structure of the cells contact system assembly can be simplified, a structure of a battery management system can be optimized, and costs can be reduced.

In an embodiment, the cells contact system assembly further includes a plurality of first thermally conductive pads, the opening is a plurality of thermally conductive holes, an opening of each thermally conductive hole faces at least one battery cell, each first thermally conductive pad is placed in the plurality of thermally conductive holes in a one-to-one correspondence, one end of each first thermally conductive pad is in contact with the thermally conductive member, and the other end of the first thermally conductive pad is in contact with at least one battery cell. Openings of the thermally conductive holes faces the plurality of battery cells, so that it can be ensured that after the thermally conductive member is disposed in the mounting groove, the thermally conductive member can be in contact with the plurality of battery cells through the first thermally conductive pads disposed in the plurality of thermally conductive holes. Disposing the first thermally conductive pad can ensure more stable contact between the thermally conductive member and the surfaces of the plurality of battery cells.

In an embodiment, the plurality of thermally conductive holes are provided in a one-to-one correspondence with the plurality of battery cells, one end of each first thermally conductive pad is in contact with the thermally conductive member, and the other end of the first thermally conductive pad is in contact with one corresponding battery cell. Alternatively, a part of the plurality of thermally conductive holes correspond to the two battery cells. In this case, the thermally conductive hole may be located between the two battery cells.

In an embodiment, the cells contact system assembly further includes a plurality of second thermally conductive pads, the opening is a groove, an extension direction of the groove is the same as an extension direction of the mounting groove, an opening of the groove faces the plurality of battery cells, the second thermally conductive pad is disposed in the groove, one end of the second thermally conductive pads is in contact with the thermally conductive member, and the other end of the second thermally conductive pads is in contact with a surface of each of the plurality of battery cells. The groove can increase a contact area between the thermally conductive member and the second thermally conductive pad, that is, increase a contact area between the thermally conductive member and each battery cell.

In an embodiment, the cells contact system assembly further includes a limiting member, the limiting member is mounted on the insulation mounting bracket, and the limiting member is configured to fasten the thermally conductive member. Disposing the limiting member can improve stability of mounting the thermally conductive member in the mounting groove.

A structure of the limiting member may be in a plurality of forms. For example, the limiting member includes a plurality of insulation screws, a plurality of snap-fits, a hot-pressing film, or the like.

In an embodiment, the limiting member is two rows of insulation screws, that is, the cells contact system assembly further includes the two rows of insulation screws. Each row of insulation screws includes a plurality of insulation screws. The two rows of insulation screws are respectively arranged on two sides of the mounting groove. A screw shaft of the insulation screw is mounted on the insulation mounting bracket, and a screw nut of the insulation screw abuts against an end that is of the thermally conductive member and that faces away from the bottom wall of the mounting groove. In this manner, the insulation screw fastens the thermally conductive member in the mounting groove, to prevent the thermally conductive member from fluttering. In an embodiment, a plurality of insulation screws may be symmetrically arranged on the two sides of the mounting groove in the extension direction of the mounting groove.

In an embodiment, the limiting member is two rows of snap-fits, that is, the cells contact system assembly further includes the two rows of snap-fits. Each row of snap-fits includes a plurality of snap-fits. The two rows of snap-fits are respectively arranged on two sides of the mounting groove. One end of the snap-fit is connected to the insulation mounting bracket, and the other end of the snap-fit abuts against a side that is of the thermally conductive member and that faces away from the bottom wall of the mounting groove. The snap-fit fastens the thermally conductive member in the mounting groove, to improve stability of mounting the thermally conductive member in the mounting groove, and prevent the thermally conductive member from fluttering. The snap-fit may include a connection section and a clamping section. One end of the connection section is connected to the insulation mounting bracket, and the other end of the connection section is connected to the clamping section. In a projection of the insulation mounting bracket, the clamping section at least partially overlaps the mounting groove, to ensure that the clamping section can abut against the thermally conductive member, and prevent the thermally conductive member from fluttering. In an embodiment, a plurality of snap-fits may be symmetrically arranged on the two sides of the mounting groove in the extension direction of the mounting groove.

In an embodiment, the limiting member is a hot-pressing film, that is, the cells contact system assembly further includes the hot-pressing film. The hot-pressing film is fastened to the insulation mounting bracket, and the thermally conductive member is fastened in the mounting groove through the hot-pressing film. It may be understood that the hot-pressing film is connected to insulation mounting brackets on two sides of the mounting groove, and the hot-pressing film covers the mounting groove, to prevent the thermally conductive member in the mounting groove from fluttering. The limiting member may include a plurality of hot-pressing films, and the plurality of hot-pressing films are sequentially spaced apart in extension of the mounting groove, to fasten the thermally conductive member in the mounting groove.

In the foregoing embodiment, the thermally conductive member may be a heat pipe, or a material of the thermally conductive member is graphene. The thermally conductive member may alternatively be another thermally conductive material.

In an embodiment, the cells contact system assembly further includes two rows of busbars, the two rows of busbars are fastened to the side that is of the insulation mounting bracket and that faces away from the battery module, an extension direction of the two rows of busbars is the same as an extension direction of the signal collection board, the two rows of busbars are located on two sides of the signal collection board, the signal collection board is electrically connected to the two rows of busbars, and the signal collection board is configured to: collect current and voltage information of the two rows of busbars, and send the current and voltage information of the two rows of busbars to the controller. The busbar is used for electrically connecting a positive electrode terminal and a negative electrode terminal of two adjacent battery cells. Disposing the signal collection board between the two rows of busbars can simplify connections between the signal collection board and the two rows of busbars.

In an embodiment, the insulation mounting bracket includes two rows of avoidance holes. Each row of avoidance holes corresponds to one row of busbars. The busbar is electrically connected to the battery cell through the avoidance hole. This improves convenience of connecting the cells contact system assembly and a battery pack.

According to a second aspect, this application further provides a battery pack, including a battery module and the cells contact system assembly in any technical solution of the first aspect. The battery module includes a plurality of battery cells that are sequentially arranged, the cells contact system assembly is fastened to electrode terminal sides of the plurality of battery cells, a thermally conductive member is attached to the plurality of battery cells through an opening, and the CCS assembly is configured to detect temperatures of the plurality of battery cells. When one or more of the plurality of battery cells are faulty and there is temperature abnormality, a temperature of the thermally conductive member also changes with a temperature of the battery cell. A temperature sensor disposed on the thermally conductive member can collect the temperature of the thermally conductive member in real time, and transmit collected temperature information to a controller through a signal collection board, so that an exception of the battery pack can be found in time, and working safety of the battery pack is improved. In addition, only one temperature sensor is required to detect the battery pack, so that a structure layout can be optimized, and costs are reduced.

According to a third aspect, this application further provides an energy storage system. The energy storage system includes a power converter and the battery pack in any technical solution of the second aspect. The power converter is configured to: perform power conversion on voltages output by the plurality of battery packs, and output converted voltages to a power grid or a load; or perform power conversion on a voltage output by an external power supply, and output a converted voltage to the battery pack.

### BRIEF DESCRIPTION OF DRAWINGS

FIG. 1 is a diagram of a structure of a battery pack according to an embodiment of this application;
FIG. 2 is a diagram of a structure of a cells contact system assembly according to an embodiment of this application;
FIG. 3 is an exploded view of a cells contact system assembly according to an embodiment of this application;
FIG. 4 is another exploded view of a cells contact system assembly according to an embodiment of this application;
FIG. 5 is a diagram of a structure of an insulation mounting bracket in a cells contact system assembly according to an embodiment of this application;
FIG. 6 is a diagram of a structure of a signal collection board in a cells contact system assembly according to an embodiment of this application;
FIG. 7 is a diagram of a partial structure in which a signal collection board is electrically connected to a temperature sensor in a cells contact system assembly according to an embodiment of this application;
FIG. 8 is a diagram of a partial structure in which a limiting member is disposed on an insulation mounting bracket in a cells contact system assembly according to an embodiment of this application;
FIG. 9 is a diagram of another partial structure in which a limiting member is disposed on an insulation mounting bracket in a cells contact system assembly according to an embodiment of this application;
FIG. 10 is a diagram of another partial structure in which a limiting member is disposed on an insulation mounting bracket in a cells contact system assembly according to an embodiment of this application; and
FIG. 11a and FIG. 11b are diagrams of connection structures of an energy storage system according to an embodiment of this application.

### Reference numerals:

10: battery pack; 11: fastening bracket; 110: first bracket; 111: second bracket; 112: connection plate; 12: battery module; 120: battery cell; 20: cells contact system assembly; 21: signal collection board; 210: pin; 211: electrical connection portion; 22: busbar; 220: positioning hole; 23: insulation mounting bracket; 230: mounting groove; 231: thermally conductive hole; 232: avoidance hole; 233: positioning pillar; 234: groove; 24: thermally conductive member; 25: temperature sensor; 26: first thermally conductive pad; 27: limiting member; 270: insulation screw; 271: snap-fit; 2710: connection section; 2711: clamping section; 272: hot-pressing film; 28: second thermally conductive pad.

### DESCRIPTION OF EMBODIMENTS

To make objectives, technical solutions, and advantages of this application clearer, the following further describes this application in detail with reference to the accompanying drawings.

An electric vehicle or another static energy storage system includes a battery management system. The battery management system includes a battery monitoring unit and a battery module. A capacitor of the battery monitoring unit is configured to monitor a running status of the battery module. In a conventional technology, the battery module includes a plurality of battery cells, and the battery monitoring unit is usually electrically connected to the plurality of battery cells through a plurality of temperature sensors, to collect temperature information of different unused battery cells, and detect the different battery cells. This reduces a possibility of battery danger. In this manner, although the plurality of temperature sensors can detect abnormality of the battery cells, because there are a large quantity of temperature sensors, a structure of the battery management system is complex, and costs are high.

Terms used in the following embodiments are merely intended to describe specific embodiments, but are not intended to limit this application. The terms "one", "a", "the", "the foregoing", "this", and "the one" of singular forms used in this specification and the appended claims of this application are also intended to include forms such as "one or more", unless otherwise specified in the context clearly.

Reference to "an embodiment", "some embodiments", or the like described in this specification indicates that one or more embodiments of this application include a specific feature, structure, or characteristic described with reference to embodiments. Therefore, statements such as "in an embodiment", "in some embodiments", "in some other embodiments", and "in other embodiments" that appear at different places in this specification do not necessarily mean reference to a same embodiment. Instead, the statements mean "one or more but not all of embodiments", unless otherwise specifically emphasized in another manner. The terms "include", "comprise", "have", and their variants all mean "include but are not limited to", unless otherwise specifically emphasized in another manner.

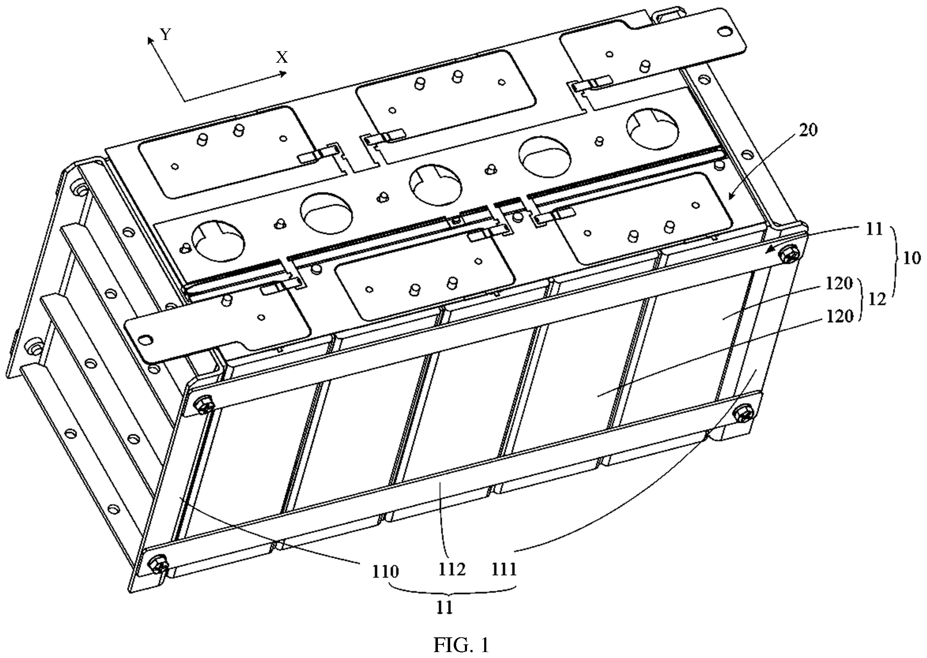

FIG. 1 is a diagram of a structure of a battery pack according to an embodiment of this application. Refer to FIG. 1. The battery pack 10 includes a fastening bracket 11, a battery module 12, and a cells contact system assembly 20. The battery module 12 includes a plurality of battery cells 120 that are sequentially arranged in a first direction X, and the fastening bracket 11 is configured to fasten the plurality of battery cells 120. Each battery cell 120 includes a positive electrode terminal and a negative electrode terminal, and the positive electrode terminal and the negative electrode terminal that are included in each battery cell 120 are located on a same side of the battery cell 120. The positive electrode terminal and the negative electrode terminal on each battery cell 120 are arranged in a second direction Y, and there is a gap between the positive electrode terminal and the negative electrode terminal on each battery cell 120. The cells contact system assembly 20 is fastened to electrode terminal sides of the plurality of battery cells 120, and the cells contact system assembly 20 is configured to electrically connect to positive electrode terminals and negative electrode terminals of the plurality of battery cells 120. The cells contact system assembly 20 can collect a temperature of each battery cell 120, and send the detected temperature to a battery monitoring unit. The battery monitoring unit may be understood as a controller. The battery monitoring unit can determine, based on temperature information detected by the cells contact system assembly 20, whether the battery module 12 is overheated, to prevent the battery module 12 from causing, due to overheating, a hazard, for example, a fire.

In an embodiment, the fastening bracket 11 includes accommodation space, and the plurality of battery cells 120 are sequentially arranged in the accommodation space in the first direction. A shape of the fastening bracket 11 may be a circle, a rectangle, a rhombus, or the like. A shape of the battery cell 120 may be a long strip shape, a cylindrical shape, or the like. The fastening bracket 11 includes a first bracket 110, a second bracket 111, and a plurality of connection plates 112. The plurality of connection plates 112 connect the first bracket 110 and the second bracket 111, to form the accommodation space for accommodating the plurality of battery cells 120. In the first direction X, one piece of fireproof cotton is disposed between the first bracket 110 and one battery cell 120 located at one end, and one piece of fireproof cotton may also be disposed between the second bracket 111 and one battery cell 120 located at the other end. In some other embodiments, each of the first bracket 110 and the second bracket 111 may include at least four side plates. The at least four side plates enclose one accommodation cavity. The first bracket 110 and the second bracket 111 are arranged in a height direction of the battery cell. An accommodation cavity of the first bracket 110 and an accommodation cavity of the second bracket 111 may communicate with each other, to fasten the plurality of battery cells.

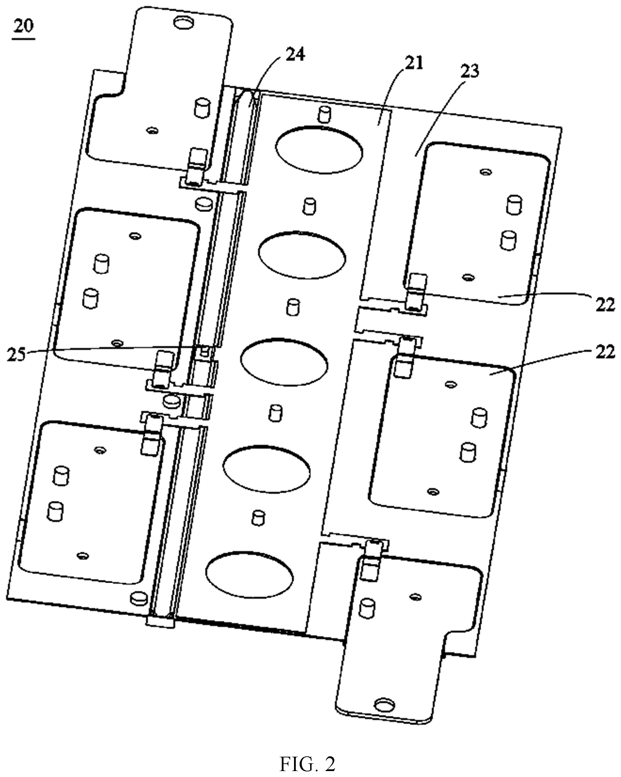

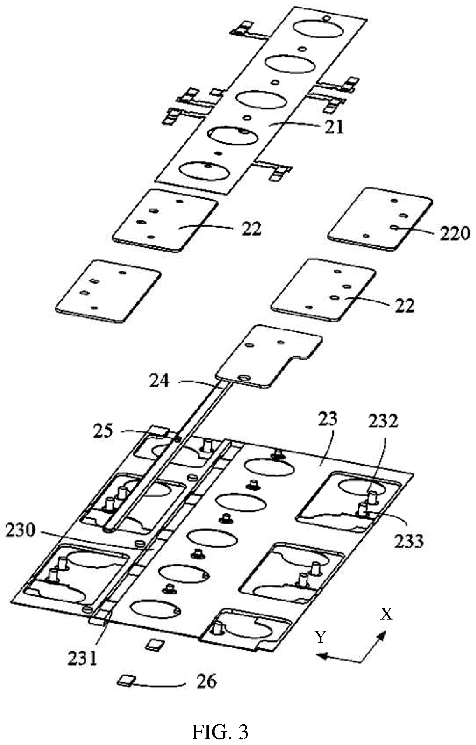

FIG. 2 is a diagram of a structure of the cells contact system assembly according to an embodiment of this application. FIG. 3 is an exploded view of the cells contact system assembly according to an embodiment of this application. FIG. 3 is an exploded view of FIG. 2. Refer to FIG. 1, FIG. 2, and FIG. 3. In an embodiment, the cells contact system assembly 20 includes a signal collection board 21, an insulation mounting bracket 23, a thermally conductive member 24, and a temperature sensor 25. The signal collection board 21 is any one of an FPC, a PCB, or an FFC. The thermally conductive member 24 may be in a plurality of structural forms. For example, the thermally conductive member 24 is a heat pipe, or a material of the thermally conductive member 24 is a graphene material. The thermally conductive member 24 may alternatively be in another structural form. This is not enumerated herein. The insulation mounting bracket 23 is fastened to a surface of the battery module 12. Specifically, the battery module 12 includes the plurality of battery cells 120 that are sequentially arranged in the first direction X. The insulation mounting bracket 23 is fastened to the electrode terminal sides of the plurality of battery cells 120. The insulation mounting bracket 23 includes a mounting groove 230, that the mounting groove 230 extends in an arrangement direction of the plurality of battery cells 120 may be understood as that the mounting groove 230 extends in the first direction X. The thermally conductive member 24 is mounted in the mounting groove 230. A bottom wall of the mounting groove 230 includes an opening, the opening faces the plurality of battery cells 120, and the thermally conductive member 24 is in contact with surfaces of the plurality of battery cells 120 through the opening for heat conduction. The temperature sensor 25 is in contact with a surface of the thermally conductive member 24, to collect temperature information of the thermally conductive member 24. The signal collection board 21 is fastened to a side that is of the insulation mounting bracket 23 and that faces away from the battery module 12. The signal collection board 21 is electrically connected to the temperature sensor 25. The signal collection board 21 is configured to: receive the temperature information collected by the temperature sensor 25, and transmit, to the controller, the temperature information collected by the temperature sensor 25. In this embodiment, the controller can determine, based on a signal transmitted by the signal collection board 21, whether the plurality of battery cells 120 are overheated, to prevent the plurality of battery cells 120 from causing, due to overheating, a hazard, for example, a fire. The thermally conductive member 24 is in contact with the surfaces of the plurality of battery cells 120, and heat generated by each battery cell 120 can be transferred to the thermally conductive member 24. When any one or more of the plurality of battery cells 120 are faulty and there is temperature abnormality, a temperature of the thermally conductive member 24 also changes with a temperature of the battery cell 120. The temperature sensor 25 disposed on the thermally conductive member 24 can collect the temperature of the thermally conductive member 24 in real time. It may be understood that one temperature sensor 25 in contact with the surface of the thermally conductive member 24 can collect temperatures of the plurality of battery cells 120 in real time, and send a collected signal to the controller through the signal collection board 21, so that an exception of the battery module 12 can be detected in time, and a danger caused by an excessively high temperature of the battery module 12 can be prevented. In this manner, only one temperature sensor 25 electrically connected to the signal collection board 21 needs to be disposed on the thermally conductive member 24, and the temperature sensor 25 can detect abnormal temperatures of the plurality of battery cells 120 through the thermally conductive member 24, to reduce a quantity of temperature sensors 25 and reduce a quantity of lines connected to the temperature sensor 25. In this way, the structure of the cells contact system assembly 20 is simplified, and costs of the cells contact system assembly 20 are reduced, to reduce costs of the entire battery pack 10.

In an embodiment, the cells contact system assembly 20 further includes two rows of busbars 22. The two rows of busbars 22 are fastened to the side that is of the insulation mounting bracket 23 and that faces away from the battery module 12. An extension direction of the two rows of busbars 22 is the same as an extension direction of the signal collection board 21. The two rows of busbars 22 are located on two sides of the signal collection board 21. The signal collection board 21 is electrically connected to the two rows of busbars 22. The signal collection board 21 is configured to: collect current and voltage information of the two rows of busbars 22, and send the current and voltage information of the two rows of busbars 22 to the controller. Each row of busbars 22 is adjacent to the signal collection board in the second direction Y, and there is a gap between the row of busbars 22 and the signal collection board. Each row of busbars 22 includes a plurality of busbars 22, the plurality of busbars 22 are sequentially arranged in the first direction X, there is a gap between two adjacent busbars 22, and each busbar 22 is an aluminum busbar. One row of busbars 22 is configured to electrically connect a positive electrode terminal and a negative electrode terminal on two adjacent battery cells 120 in the first direction X, so that the two adjacent battery cells 120 are connected in series, the other row of busbars 22 electrically connects a positive electrode terminal and a negative electrode terminal on two adjacent battery cells 120 in the first direction X, so that the two adjacent battery cells 120 are connected in series. The signal collection board 21 is electrically connected to the two rows of busbars 22. In addition, an end of one busbar 22 located at an end portion in the first direction X extends to an outer side of the battery module 12. Parts that are of the two rows of busbars 22 and that extend to an outer side of the battery pack 10 are located on two sides of the battery module 12 in the first direction.

Still refer to FIG. 3. The insulation mounting bracket 23 includes two rows of positioning pillars 233, the two rows of positioning pillars 233 are arranged in the second direction Y, there is a gap between the two rows of positioning pillars 233, each row of positioning pillars 233 includes a plurality of positioning pillars 233 arranged in the first direction X, and there is a gap between two adjacent positioning pillars 233. Each busbar 22 includes at least one positioning hole 220, the at least one positioning hole 220 corresponds to one positioning pillar 233, and the positioning pillar 233 passes through the positioning hole 220, so that the busbar 22 is fastened to the insulation mounting bracket 23.

Still refer to FIG. 1, FIG. 2, and FIG. 3. In an embodiment, the cells contact system assembly 20 further includes a plurality of first thermally conductive pads 26. The opening is a plurality of thermally conductive holes 231, the plurality of thermally conductive holes 231 are arranged in the first direction X, and an opening of each thermally conductive hole 231 faces at least one battery cell 120. The plurality of first thermally conductive pads 26 are placed in the plurality of thermally conductive holes 231 in a one-to-one correspondence. One end of each first thermally conductive pad 26 is in contact with the thermally conductive member 24, and the other end of the first thermally conductive pad 26 is in contact with at least one battery cell 120. Disposing the first thermally conductive pad 26 can make contact between the thermally conductive member 24 and the plurality of battery cells 120 more stable, and the temperatures of the battery cells 120 be more stably transferred to the thermally conductive member 24. When the cells contact system assembly 20 includes the plurality of first thermally conductive pads 26, heat generated by the battery cells 120 may be transferred to the thermally conductive member 24 through the first thermally conductive pads 26. When any one or more of the plurality of battery cells 120 are faulty and there is temperature abnormality, a temperature of the first thermally conductive pad 26 changes with a temperature of the battery cell 120. Therefore, the temperature of the thermally conductive member 24 also changes with the temperature of the battery cell 120, the temperature sensor 25 disposed on the thermally conductive member 24 can collect the temperature of the thermally conductive member 24 in real time, and transmit the collected temperature to the controller through the signal collection board 21. The controller can monitor the battery module 12 based on temperature information detected by the temperature sensor 25, to prevent a danger.

In an embodiment, five thermally conductive holes correspond to five battery cells, that is, each thermally conductive hole 231 corresponds to one battery cell 120. In this case, one end of one first thermally conductive pad 26 is in contact with one battery cell 120, and the other end of the first thermally conductive pad 26 is in contact with the thermally conductive member 24 through one thermally conductive hole 231. In some other embodiments, at least one of the plurality of thermally conductive holes 231 may correspond to two battery cells. In this case, a length of one thermally conductive hole 231 is increased in the first direction X, and a length of the first thermally conductive pad 26 is also increased in the first direction X, so that one first thermally conductive pad 26 disposed in the thermally conductive hole 231 can be in contact with two battery cells 120.

It should be noted that, when each thermally conductive hole 231 corresponds to one battery cell 120, a connection line between centers of the plurality of thermally conductive holes 231 may be a curve, a broken line, or an inclined straight line. In this case, the thermally conductive member 24 is in a curve shape, a broken line shape, or a straight line shape. Similarly, a shape of the mounting groove 230 also changes accordingly.

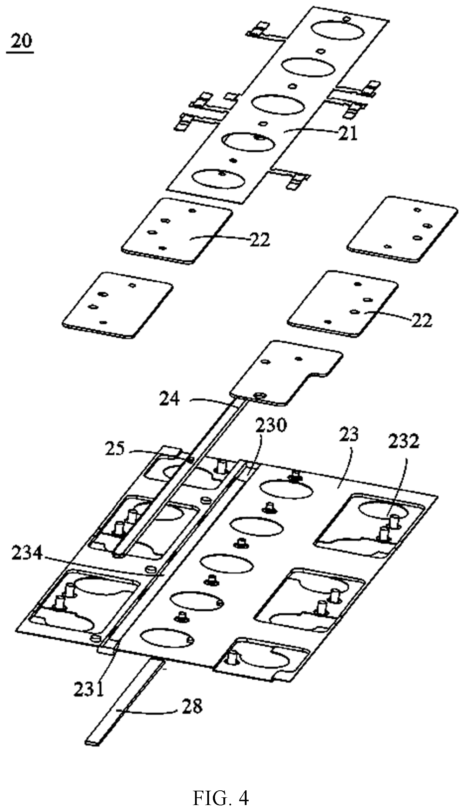

FIG. 4 is another exploded view of the cells contact system assembly according to an embodiment of this application. FIG. 4 is an exploded view of FIG. 2. Refer to FIG. 1, FIG. 2, and FIG. 4. In an embodiment, the cells contact system assembly 20 further includes a plurality of second thermally conductive pads 28. The opening is a groove 234, and an extension direction of the groove 234 is the same as an extension direction of the mounting groove 230, and an opening of the groove faces the plurality of battery cells 120. The second thermally conductive pad 28 is disposed in the groove 234. One end of the second thermally conductive pads 28 is in contact with the thermally conductive member 24, and the other end of the second thermally conductive pads 28 is in contact with a surface of each of the plurality of battery cells 120. In this manner, a length of the groove 234 is less than a length of the mounting groove 230, that is, the length of the groove 234 is less than a length of the bottom wall of the mounting groove 230. The opening of the groove 234 faces top surfaces of the plurality of battery cells 120. This may be understood as follows: The opening of the groove 234 faces a side that is of the plurality of battery cells 120 and that has a positive electrode terminal and a negative electrode terminal. Because the second thermally conductive pads 28 are in contact with top surfaces of the battery cells 120, a temperature of the second thermally conductive pad 28 changes with temperatures of the top surfaces of the battery cells 120. The second thermally conductive pad 28 transfers the temperature to the thermally conductive member 24, and the temperature sensor 25 in contact with the surface of the thermally conductive member 24 can collect temperature information of the thermally conductive member 24, and send the information to the controller through the signal collection board 21, to monitor the plurality of battery cells 120.

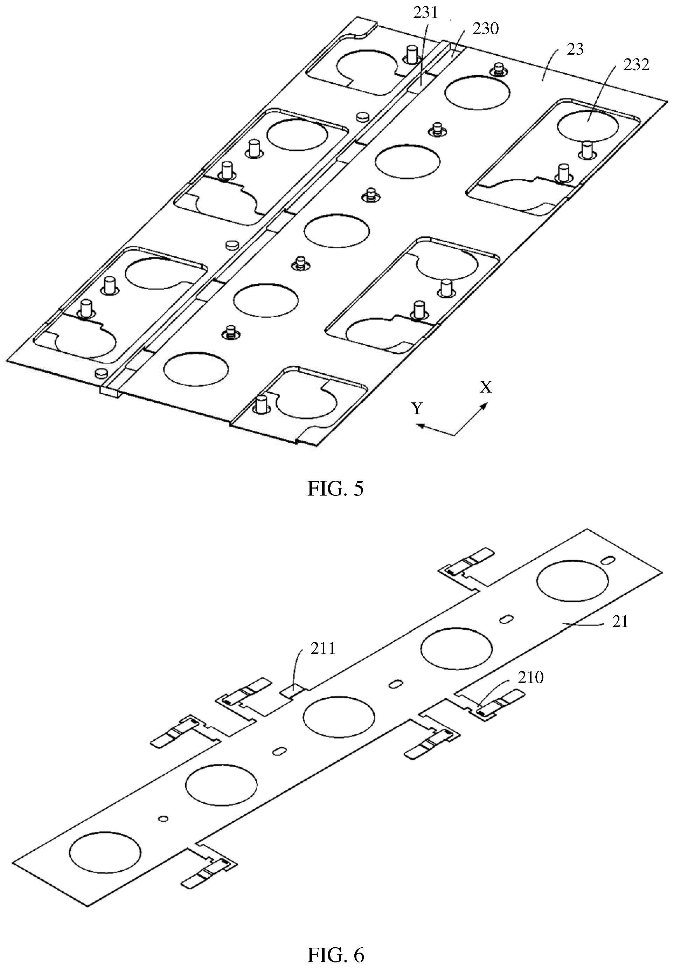

FIG. 5 is a diagram of a structure of the insulation mounting bracket in the cells contact system assembly according to an embodiment of this application. Refer to FIG. 2 to FIG. 5. In an embodiment, the insulation mounting bracket 23 includes two rows of avoidance holes 232. The two rows of avoidance holes 232 are adjacent in the second direction Y, and there is a gap between the two rows of avoidance holes 232, each row of avoidance holes 232 includes a plurality of avoidance holes 232 spaced apart in the first direction X. Each row of avoidance holes 232 corresponds to one row of busbars 22. One row of busbars 22 is electrically connected, through one row of avoidance holes 232, to the positive electrode terminals and the negative electrode terminals that are included in the plurality of battery cells, and the other row of busbars 22 is electrically connected, through the other row of avoidance holes 232, to the positive electrode terminals and the negative electrode terminals that are included in the plurality of battery cells.

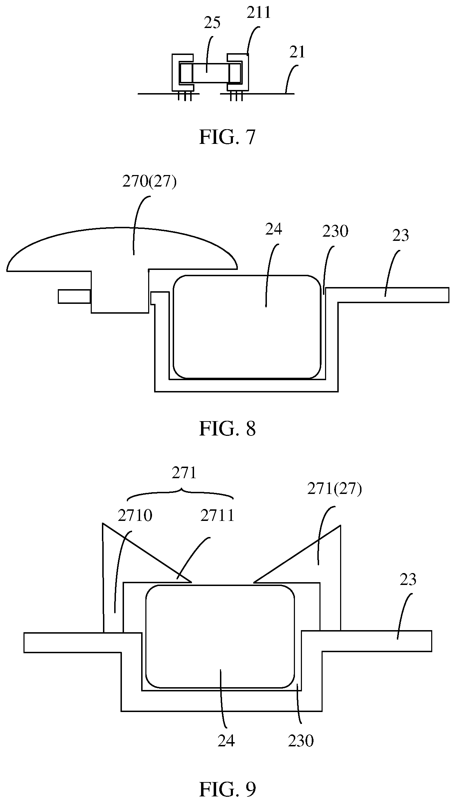

FIG. 6 is a diagram of a structure of the signal collection board in the cells contact system assembly according to an embodiment of this application. Refer to FIG. 3 and FIG. 6. In an embodiment, the signal collection board 21 includes a plurality of pins 210. The plurality of pins 210 are arranged on the two sides of the signal collection board 21, a quantity of pins 210 on each side of the signal collection board 21 is the same as a quantity of busbars 22 included in one row of busbars, and each pin 210 is electrically connected to one busbar 22. FIG. 7 is a diagram of a partial structure in which the signal collection board is electrically connected to the temperature sensor in the cells contact system assembly according to an embodiment of this application. Refer to FIG. 6 and FIG. 7. The signal collection board 21 further includes an electrical connection portion 211, and the electrical connection portion 211 is electrically connected to the temperature sensor. The electrical connection portion 211 is connected to the temperature sensor 25 through welding or by using a puncture crimping process, and the electrical connection portion 211 is further fastened to the thermally conductive member through glue dispensing.

In the foregoing embodiment, there may alternatively be two electrical connection portions 211, there may alternatively be two temperature sensors 25, both the two temperature sensors 25 are in contact with the thermally conductive member 24, and both the two temperature sensors 25 can detect the temperatures of the plurality of battery cells. When any temperature sensor 25 is damaged or abnormal, detection of the plurality of battery cells is not affected, and working safety of the battery module can be improved.

In an embodiment, the cells contact system assembly further includes a limiting member. The limiting member is mounted on the side that is of the insulation mounting bracket and that faces away from the battery module. The limiting member can be configured to fasten the thermally conductive member disposed in the mounting groove, to prevent the battery module from fluttering out of the mounting groove as the thermally conductive member vibrates. This improves working stability of the battery module.

A structure of the limiting member may be in a plurality of forms. Specifically, the structure of the limiting member may be an insulation screw, a snap-fit, a hot-pressing film, or the like. The limiting member is described below as an insulation screw, a snap-fit, or a hot-pressing film, separately.

FIG. 8 is a diagram of a partial structure in which the limiting member is disposed on the insulation mounting bracket in the cells contact system assembly according to an embodiment of this application. Refer to FIG. 5 and FIG. 8. In an embodiment, the limiting member 27 includes two rows of insulation screws 270, that is, the cells contact system assembly includes the two rows of insulation screws 270. The two rows of insulation screws 270 are respectively arranged on two sides of the mounting groove. A screw shaft of the insulation screw 270 is connected to the insulation bracket 23, and a screw nut of the insulation screw 270 is configured to abut against an end that is of the thermally conductive member 24 and that faces away from the bottom wall of the mounting groove 230. The insulation screw 270 fastens the thermally conductive member 24 in the mounting groove 230, to prevent the thermally conductive member 24 from fluttering. Each row of insulation screws 270 includes a plurality of insulation screws 270. A plurality of insulation screws 270 arranged on the two sides of the mounting groove 230 may be symmetrically disposed, or a plurality of insulation screws 270 arranged on the two sides of the mounting groove 230 may be partially symmetrical.

FIG. 9 is a diagram of another partial structure in which the limiting member is disposed on the insulation mounting bracket in the cells contact system assembly according to an embodiment of this application. Refer to FIG. 5 and FIG. 9. In an embodiment, the limiting member 27 includes two rows of snap-fits 271, that is, the cells contact system assembly includes the two rows of snap-fits 271. The two rows of snap-fits 271 are respectively arranged on two sides of the mounting groove 230. One end of the snap-fit 271 is connected to the side that is of the insulation mounting bracket 23 and that faces away from the battery module, and the other end of the snap-fit 271 is configured to abut against one end that is of the thermally conductive member 24 and that faces away from the bottom wall of the mounting groove 230. The snap-fit 271 includes a connection section 2710 and a clamping section 2711. One end of the connection section 2710 is connected to the side that is of the insulation mounting bracket 23 and that faces away from the battery module, and the other end of the connection section 2710 is connected to the clamping section 2711. In a projection of the insulation mounting bracket 23, the clamping section 2711 at least partially overlaps the mounting groove 230, to ensure that the clamping section 2711 can abut against the thermally conductive member 24, and prevent the thermally conductive member 24 from fluttering. Each row of snap-fits 271 includes a plurality of snap-fits. A plurality of snap-fits 271 arranged on the two sides of the mounting groove 230 may be symmetrically disposed, or a plurality of snap-fits 271 arranged on the two sides of the mounting groove 230 may be partially symmetrical.

It should be noted that a cross-sectional shape of the clamping section 2711 may be a triangle, a rectangle, a rhombus, a semicircle, or the like, provided that in the projection of the insulation mounting bracket 23, the clamping section 2711 can at least partially overlap the mounting groove, so that the thermally conductive member 24 does not flutter in a thickness direction of the insulation mounting bracket 23.

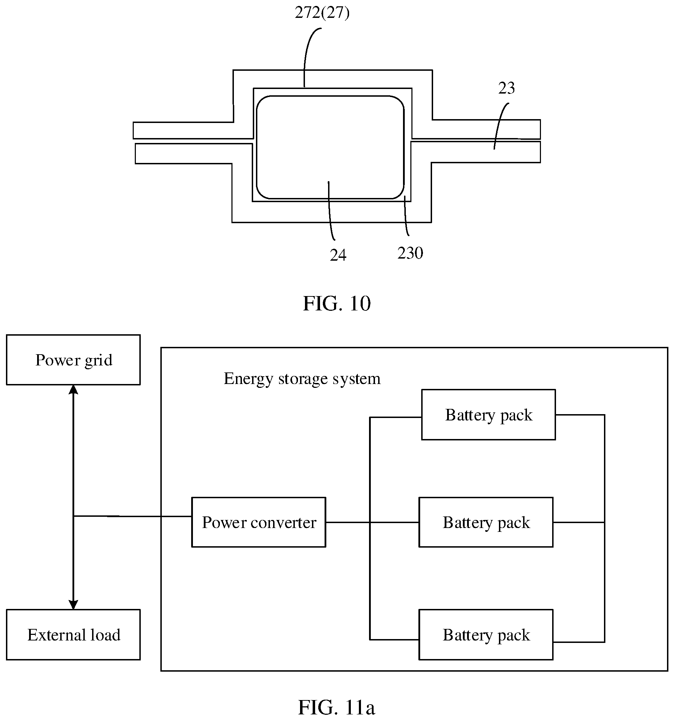

FIG. 10 is a diagram of another partial structure in which the limiting member is disposed on the insulation mounting bracket in the cells contact system assembly according to an embodiment of this application. Refer to FIG. 5 and FIG. 10. In an embodiment, the limiting member 27 includes a hot-pressing film 272. The hot-pressing film 272 is fastened to the side that is of the insulation mounting bracket 23 and that faces away from the battery module. In a projection of the insulation mounting bracket 23, the hot-pressing film 272 covers at least a part of the mounting groove 230. It may be understood that the hot-pressing film 272 is connected to insulation mounting brackets 23 on the two sides of the mounting groove 230, and the hot-pressing film 272 covers the mounting groove 230, to fasten the thermally conductive member 24 in the mounting groove 230, and prevent the thermally conductive member 24 in the mounting groove 230 from fluttering. There may be a plurality of hot-pressing films 272, the plurality of hot-pressing films 272 are sequentially arranged in the extension direction of the mounting groove 230, and there is a gap between two adjacent hot-pressing films 272.

In the foregoing embodiment, the thermally conductive member 24 may include a plurality of protrusion portions, the plurality of protrusion portions are disposed in a one-to-one correspondence with the plurality of thermally conductive holes 231, the plurality of protrusion portions penetrate the thermally conductive holes 231, and each protrusion portion is in contact with a surface of one battery cell. The protrusion portions can collect temperatures of the plurality of battery cells, and transmit the temperatures through the temperature sensor 25 disposed on the thermally conductive member 24. In this case, the plurality of protrusion portions may be considered as a first thermally conductive pad.

In an embodiment, the thermally conductive member 24 may include one protrusion portion, the protrusion portion corresponds to the groove, and the protrusion portion passes through the groove and is in contact with the surfaces of the plurality of battery cells, to collect the temperatures of the battery cells, and transmit the temperatures through the temperature sensor 25 disposed on the thermally conductive member 24. In this case, a plurality of protrusion portions may be considered as a second thermally conductive pad.

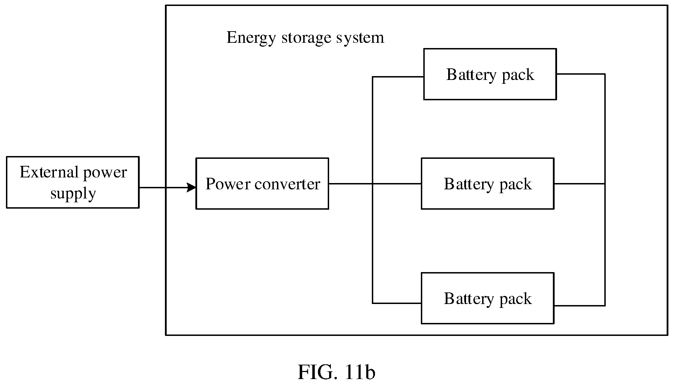

An embodiment of this application further provides an energy storage system. FIG. 11a and FIG. 11b are diagrams of connection structures of an energy storage system. Refer to FIG. 11a and FIG. 11b. The energy storage system includes a battery pack and a power converter in this application. The power converter is configured to perform power conversion on a voltage output by the battery pack, and then output a converted voltage to a power grid or an external load. Alternatively, the power converter is configured to perform power conversion on a voltage output by an external power supply, and then output a converted voltage to the battery pack. The battery pack may be connected to a photovoltaic module, and the battery pack is charged by using the photovoltaic module.

It should be noted that the battery pack provided in this embodiment of this application may be further used in an electric vehicle.

It is clear that a person skilled in the art can make various modifications and variations to this application without departing from the scope of this application. In this case, this application is intended to cover these modifications and variations of this application provided that they fall within the scope of protection defined by the claims of this application and their equivalent technologies.

## Claims

1. A cells contact system CCS assembly, wherein the CCS assembly comprises a signal collection board, an insulation mounting bracket, a thermally conductive member, and a temperature sensor;
the insulation mounting bracket is configured to be fastened to a surface of a battery module, the battery module comprises a plurality of battery cells that are sequentially arranged, the insulation mounting bracket comprises a mounting groove, and the mounting groove extends in an arrangement direction of the plurality of battery cells;
the thermally conductive member is mounted in the mounting groove, a bottom wall of the mounting groove comprises an opening, the opening faces the plurality of battery cells, and the thermally conductive member is in contact with surfaces of the plurality of battery cells through the opening for heat conduction;
the temperature sensor is in contact with a surface of the thermally conductive member, to collect temperature information of the thermally conductive member; and
the signal collection board is fastened to a side that is of the insulation mounting bracket and that faces away from the battery module, the signal collection board is electrically connected to the temperature sensor, and the signal collection board is configured to receive the temperature information collected by the temperature sensor.

2. The CCS assembly according to claim 1, wherein the CCS assembly further comprises a plurality of first thermally conductive pads, the opening is a plurality of thermally conductive holes, an opening of each thermally conductive hole faces at least one battery cell, the plurality of first thermally conductive pads are placed in the plurality of thermally conductive holes in a one-to-one correspondence, one end of each first thermally conductive pad is in contact with the thermally conductive member, and the other end of the first thermally conductive pad is in contact with at least one battery cell.

3. The CCS assembly according to claim 2, wherein the plurality of thermally conductive holes are provided in a one-to-one correspondence with the plurality of battery cells, one end of each first thermally conductive pad is in contact with the thermally conductive member, and the other end of the first thermally conductive pad is in contact with one corresponding battery cell.

4. The CCS assembly according to claim 1, wherein the CCS assembly further comprises a plurality of second thermally conductive pads, the opening is a groove, an extension direction of the groove is the same as an extension direction of the mounting groove, an opening of the groove faces the plurality of battery cells, the second thermally conductive pad is disposed in the groove, one end of the second thermally conductive pads is in contact with the thermally conductive member, and the other end of the second thermally conductive pads is in contact with a surface of each of the plurality of battery cells.

5. The CCS assembly according to any one of claims 1 to 4, wherein the CCS assembly further comprises two rows of insulation screws, each row of insulation screws comprises a plurality of insulation screws, the two rows of insulation screws are respectively arranged on two sides of the mounting groove, a screw shaft of the insulation screw is mounted on the insulation mounting bracket, and a screw nut of the insulation screw abuts against an end that is of the thermally conductive member and that faces away from the bottom wall of the mounting groove.

6. The CCS assembly according to any one of claims 1 to 4, wherein the CCS assembly further comprises two rows of snap-fits, each row of snap-fits comprises a plurality of snap-fits, the two rows of snap-fits are respectively arranged on two sides of the mounting groove, one end of the snap-fit is connected to the insulation mounting bracket, and the other end of the snap-fit abuts against an end that is of the thermally conductive member and that faces away from the bottom wall of the mounting groove.

7. The CCS assembly according to any one of claims 1 to 4, wherein the CCS assembly further comprises a hot-pressing film, the hot-pressing film is fastened to the insulation mounting bracket, and the thermally conductive member is fastened in the mounting groove through the hot-pressing film.

8. The CCS assembly according to any one of claims 1 to 7, wherein the thermally conductive member is a heat pipe, or a material of the thermally conductive member is graphene.

9. The CCS assembly according to any one of claims 1 to 8, wherein the CCS assembly further comprises two rows of busbars, the two rows of busbars are fastened to the side that is of the insulation mounting bracket and that faces away from the battery module, an extension direction of the two rows of busbars is the same as an extension direction of the signal collection board, the two rows of busbars are located on two sides of the signal collection board, the signal collection board is electrically connected to the two rows of busbars, and the signal collection board is configured to: collect current and voltage information of the two rows of busbars, and send the current and voltage information of the two rows of busbars to the controller.

10. A battery pack, comprising a battery module and the CCS assembly according to any one of claims 1 to 9, wherein the battery module comprises a plurality of battery cells that are sequentially arranged, the CCS assembly is fastened to electrode terminal sides of the plurality of battery cells, and the CCS assembly is configured to detect temperatures of the plurality of battery cells.
